(19) Europäisches Patentamt
European Patent Office
Office européen des brevets

(11) **EP 2 905 810 B1**

(12) **EUROPEAN PATENT SPECIFICATION**

(45) Date of publication and mention
of the grant of the patent:
**14.08.2019 Bulletin 2019/33**

(51) Int Cl.:
**H01L 33/20** $^{(2010.01)}$ **H01L 33/58** $^{(2010.01)}$
**H01L 25/075** $^{(2006.01)}$

(21) Application number: **15153889.9**

(22) Date of filing: **05.02.2015**

(54) **LIGHT EMITTING DEVICE PACKAGE**

LICHTEMITTIERENDE VORRICHTUNGSVERPACKUNG

BOÎTIER DE DISPOSITIF ÉLECTROLUMINESCENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.02.2014 KR 20140013148**

(43) Date of publication of application:
**12.08.2015 Bulletin 2015/33**

(73) Proprietor: **LG Innotek Co., Ltd.**
**Seoul, 04637 (KR)**

(72) Inventors:
• **Park, Gwui Youn**
**100-714 Seoul (KR)**

• **Kang, Bo Ra**
**100-714 Seoul (KR)**
• **Kim, Sung Phil**
**100-714 Seoul (KR)**

(74) Representative: **Zardi, Marco**
**M. Zardi & Co. SA**
**Via Pioda 6**
**6900 Lugano (CH)**

(56) References cited:
**US-A1- 2011 193 112     US-A1- 2011 291 131**
**US-A1- 2012 068 198     US-A1- 2012 069 545**
**US-A1- 2013 141 920     US-A1- 2013 270 581**

## Description

## BACKGROUND

### 1. Field of the Invention

The present invention relates to a light emitting device package.

### 2. Discussion of Related Art

A light emitting device such as a light emitting diode (LED) is a type of a semiconductor device that converts electric energy into optical energy through a P-N junction structure of a compound semiconductor, has a small power consumption and long life, and is capable of miniaturization and weight reduction, and thereby has been spotlighted as the next generation light source of a lighting apparatus. In recent years, a blue LED and an ultraviolet (UV) LED that use nitrides having excellent physical and chemical characteristics have been introduced. Since the blue LED or UV LED may implement white light or other monochromatic lights using a phosphor material, application fields of the LED are expanding.

A linear lighting device may be configured using such a light emitting device, and in this instance, in order to reduce the number of required light emitting devices, light emitted from the light emitting device should be more widely diffused in a specific direction. In this manner, in order to obtain an anisotropic light distribution, an anisotropic lens may be mounted, but there are difficulties in anisotropically designing and manufacturing the lens, and optical efficiency is degraded when such a lens is adopted.

Further examples of light emitting device packages and lighting apparatuses according to the prior art are known from documents US 2013/141920, US 2013/270581 and US 2011/193112.

## SUMMARY OF THE INVENTION

The present invention is directed to a light emitting device package which may obtain an anisotropic illumination distribution while applying an isotropic lens which can be easily designed and manufactured, and a light apparatus including the same.

The present invention relates to a light emitting device package according to claim 1.

According to an aspect as disclosed, there is provided a light emitting device package including: a light emitting device that has a first side extending in a first direction and a second side extending in a second direction, and is disposed on a substrate; and a molding unit that has a shape of an isotropic lens disposed on the substrate to surround the light emitting device, wherein a square root of {(length of the first side) $^2$ + (length of the second side) $^2$} is smaller than a diameter of the isotropic lens, and the length of the first side is at least 5/3 times more than the length of the second side.

Here, the isotropic lens may have an aspherical surface shape with its center recessed.

Also, a plurality of the light emitting devices is arranged in the first direction and the second direction.

Also, the number of the light emitting devices arranged in the first direction is at least 5/3 times more than the number of the light emitting devices arranged in the second direction.

Also, the first direction and the second direction intersect each other.

According to another aspect as disclosed, there is provided a light emitting device package including: a substrate; a light emitting device that is disposed on the substrate and electrically connected to the substrate; and a molding unit that is disposed on the substrate to surround the light emitting device, wherein an upper surface of the light emitting device includes two first sides parallel to each other and two second sides parallel to each other that intersect the first sides, and the first sides are formed longer than the second sides.

Here, the first side and the second side may vertically intersect each other, and a length of the first side may be at least 5/3 times more than a length of the second side.

Also, the light emitting device may include a plurality of light emitting device units.

Also, the number of the light emitting device units arranged in a direction of the first side is at least 5/3 times more than the number of the light emitting device units arranged in a direction of the second side.

Also, the molding unit may be an aspherical lens.

According to still another aspect as disclosed, there is provided a lighting apparatus including: at least one light emitting device package, wherein the light emitting device package includes a substrate, a light emitting device that is disposed on the substrate and electrically connected to the substrate, and a molding unit that is disposed on the substrate to surround the light emitting device, and wherein an upper surface of the light emitting device includes two first sides parallel to each other and two second sides parallel to each other that intersect the first sides, and the first sides are formed longer than the second sides.

Here, the first side and the second side may vertically intersect each other, and a length of the first side is at least 5/3 times more than a length of the second side.

Also, a plurality of the light emitting device packages may be provided, and arranged in a row.

## BRIEF DESCRIPTION OF THE DRAWINGS

The present disclosure comprises embodiments, some of which are embodiments of the invention as claimed. The above and other objects, features and advantages of the present invention will become more apparent to those of ordinary skill in the art by describing in detail exemplary embodiments thereof with reference to the accompanying drawings, in which:

FIG. 1 is a perspective view showing a light emitting device package according to a first comparative example;

FIG. 2 is a view showing an illumination distribution of the device shown in FIG. 1;

FIG. 3 is a perspective view showing a light emitting device package according to a second comparative example;

FIG. 4 is a view showing an illumination distribution of the device shown in FIG. 3;

FIG. 5 is a perspective view showing a light emitting device package according to a first embodiment not being part of the present invention;

FIG. 6 is a view showing an illumination distribution of the device shown in FIG. 5;

FIG. 7 is a plan view showing a light emitting device package according to a second embodiment of the present invention;

FIGS. 8 and 9 are views showing an illumination distribution of a linear lighting apparatus configured of a light emitting device package according to a comparative example; and

FIG. 10 is a view showing an illumination distribution of a linear lighting apparatus configured of a light emitting device package according to an embodiment of the present invention.

## DETAILED DESCRIPTION OF EXEMPLARY EMBODIMENTS

Example embodiments, some of which are part of the present invention, are disclosed herein. Also, specific structural and functional details disclosed herein are merely representative for purposes of describing the example embodiments of the present invention. However, the example embodiments of the present invention may be embodied in many alternate forms and should not be construed as limited to example embodiments of the present invention set forth herein.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element is referred to as being "connected" or "coupled" to another element, it can be directly connected or coupled to the other element or intervening elements may be present.

In contrast, when an element is referred to as being "directly connected" or "directly coupled" to another element, there are no intervening elements present.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Accordingly, while the invention is susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the scope of the invention as defined by the appended claims. Like numbers refer to like elements throughout the description of the figures.

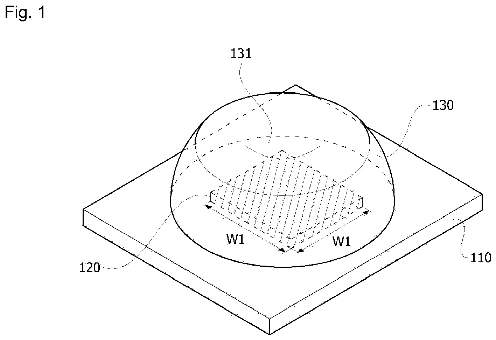

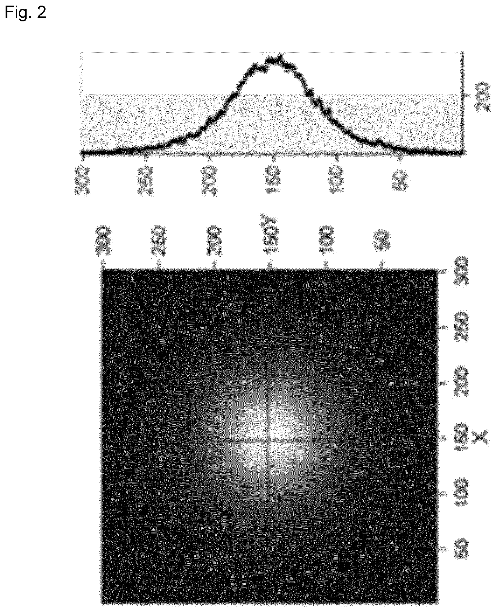

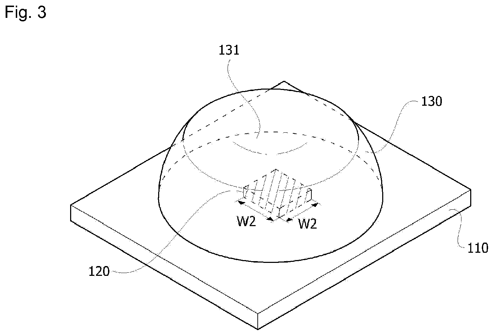

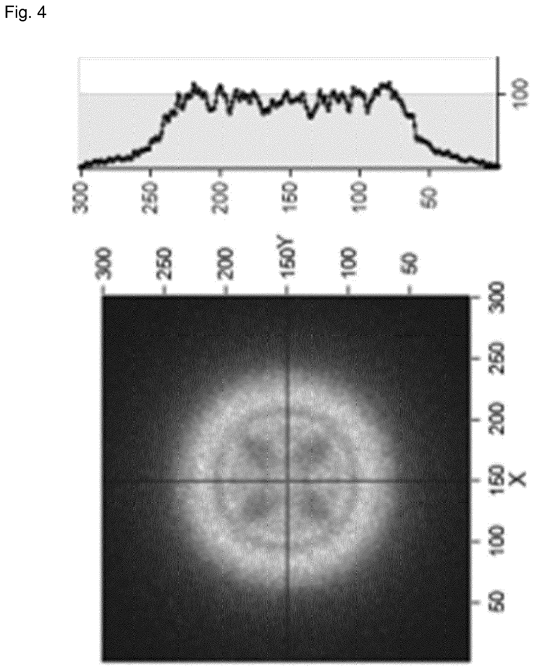

FIG. 1 is a perspective view showing a light emitting device package according to a first comparative example, FIG. 2 is a view showing an illumination distribution of the device shown in FIG. 1, FIG. 3 is a perspective view showing a light emitting device package according to a second comparative example, and FIG. 4 is a view showing an illumination distribution of the device shown in FIG. 3. Here, the unit of the numerical values shown in FIGS. 2 and 4 is mm, and X and Y respectively indicate a first direction and a second direction intersecting the first direction.

Referring to FIGS. 1 and 3, the light emitting device package according to the first and second comparative examples may include a light emitting device 120 that is disposed on a substrate 110, and a molding unit 130 that has a shape of an isotropic lens disposed on the substrate 110 to surround the light emitting device 120. The molding unit 130 may have an aspherical surface shape with a concave portion 131 recessed at the center thereof, and a planar shape of the light emitting device 120 according to the first and second comparative examples may be a square shape. As shown in the drawings, the light emitting device 120 according to the first comparative example may have a first width W1 and the light emitting device 120 according to the second comparative example may have a second width W2 relatively smaller than the first width W1.

Referring to FIGS. 2 and 4, when the molding units 130 according to the first and second comparative examples have the same shape and size, an illumination distribution may be changed depending on the size of the light emitting device 120. Specifically, it can be seen that light emitted from the light emitting device 120 having the second width W2 relatively smaller than the first width W1 is more widely diffused. However, when the planar shape of the light emitting device 120 is the square shape regardless of the size of the light emitting device 120, the light emitted from the light emitting device 120 is isotropically diffused, such as with a circular shape.

Meanwhile, in a linear lighting apparatus or the like, light is required to be more widely diffused in a specific direction, and in order to obtain such an illumination distribution, an anisotropic secondary lens may be mounted. However, it is not easy to design the anisotropic secondary lens, and manufacturing time and costs may be increased while optical efficiency is degraded when the anisotropic secondary lens is applied to a product.

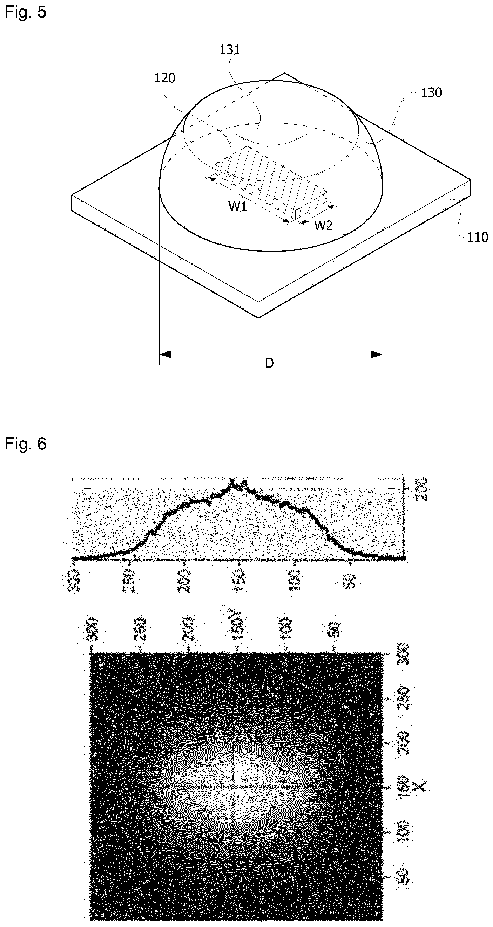

FIG. 5 is a perspective view showing a light emitting device package according to a first embodiment not being part of the present invention, and FIG. 6 is a view showing an illumination distribution of the device shown in FIG. 5. Here, the unit of the numerical values shown in FIG. 6 is mm, and X and Y respectively indicate a first direction and a second direction intersecting the first direction.

Referring to FIG. 5, the light emitting device package according to the first embodiment of the present invention may include a light emitting device 120 that is disposed on a substrate 110, and a molding unit that has a shape of an isotropic lens disposed on the substrate 110 to surround the light emitting device 120. A planar shape of the light emitting device 120 is a rectangular shape having a long axis W1 and a short axis W2, and a diagonal length of the light emitting device 120 should be smaller than a diameter D of the molding unit 130 so that the molding unit 130 can surround the light emitting device 120 (see, Equation 1).

[Equation 1]

$$\sqrt{(W1)^2 + (W2)^2} < D$$

The substrate 110 may be a typical printed circuit board (PCB) or a lead frame, and formed of at least one material of alumina, quartz, zirconia, forsterite, cordierite, beryllia, mullite, calcium zirconate, silicon carbide, aluminum nitride, fused silica, low temperature cofired ceramic (LTCC), plastic, graphite, and a metal.

The light emitting device 120 may be a device that emits light by recombination of minority carriers (electrons or electron holes) injected using a P-N junction structure of a compound semiconductor, and may be a light emitting diode (LED). Although not shown in the present drawing, the light emitting device 120 may be electrically connected to an electrode of the substrate 110 through a wire or the like so that power may be applied to the light emitting device 120, and when the light emitted from the light emitting device 120 is blue light, the light emitting device 120 may include a yellow-based phosphor that converts the blue light into white light. In particular, in order to obtain an anisotropic illumination distribution required for a configuration of the linear lighting apparatus, the long axis W1 of the light emitting device 120 should be longer than the short axis W2 thereof by at least 5/3 times or more, and the anisotropy of the illumination distribution may be increased by increasing a ratio (W1/W2) of the long axis and the short axis of the light emitting device 120.

The molding unit 130 is a lens-integrated type package having the function of a lens while protecting the light emitting device 120, and may have an aspherical surface shape with the concave portion 131 recessed at the center thereof, and therefore it is possible to increase a directional angle of the light emitted from the light emitting device 120. Meanwhile, since the light emitted from the light emitting device 120 should be transmitted to the outside, the molding unit 130 may be formed of transparent resin such as silicon resin or epoxy resin, and a dispersant or a phosphor may be added inside the molding unit 130 according to need.

Referring to FIG. 6, the light emitting device package according to the first embodiment of the present invention may obtain the anisotropic illumination distribution by applying the molding unit 130 having the shape of the isotropic lens which can be easily designed and manufactured. Specifically, the light emitted from the light emitting device 120 is more widely diffused in a direction of the short axis W2 rather than in the direction of the long axis W1, and thereby an oval-shaped light distribution appears. Meanwhile, in order to control the light distribution in the direction of the long axis W1 when the molding unit 130 is designed, the light distribution of the square-shaped light emitting device 120 having the first width W1 as shown in the first comparative example may be utilized. Similarly, in order to control the light distribution in the direction of the short axis W2, the light distribution of the square-shaped light emitting device 120 having the second width W2 as shown in the second comparative example may be utilized.

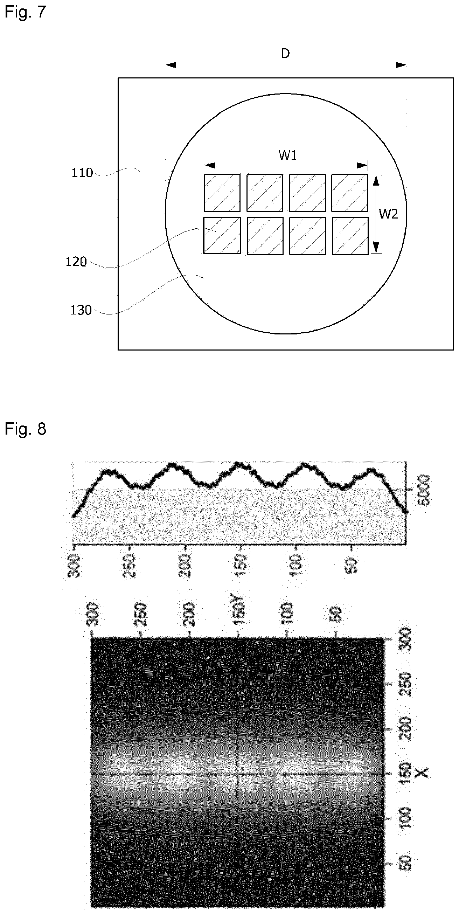

FIG. 7 is a plan view showing a light emitting device package according to a second embodiment being part of the present invention. In the description of the present embodiment, detailed description of substantially the same part as that of the above-described first embodiment will be omitted.

Referring to FIG. 7, the light emitting device package according to the second embodiment of the present invention may include a plurality of light emitting devices 120 that are arranged on the substrate 110 so as to have a rectangular shape having the long axis W1 and the short axis W2, and the isotropic lens-shaped molding unit 130 that is disposed on the substrate 110 to surround the plurality of light emitting devices 120. A planar shape of each of the light emitting devices 120 is a rectangular shape, and a diagonal length of the rectangular shape formed by arranging the plurality of light emitting devices 120 should be smaller than the diameter D of the molding unit 130 so that the molding unit 130 can surround the whole of the plurality of light emitting devices 120 (see, Equation 1).

The substrate 110 may be a typical PCB or a lead frame, and formed of a material such as that of the first embodiment. In addition, the light emitting device 120 is a device that emits light such as an LED. When each of the light emitting devices 120 has a square shape and the same size, in order to obtain an anisotropic illumination distribution required for a configuration of the linear lighting apparatus, the number of the light emitting devices 120 arranged in the direction of the long axis W1 should be larger than the number of the light emitting devices 120 arranged in the direction of the short axis W2 by at least 5/3 times or more. Meanwhile, the molding unit 130 may be a lens-integrated type package having the function of a lens while protecting the light emitting device 120, have an aspherical surface shape with its center recessed, and be formed of transparent resin such as silicon resin or epoxy resin.

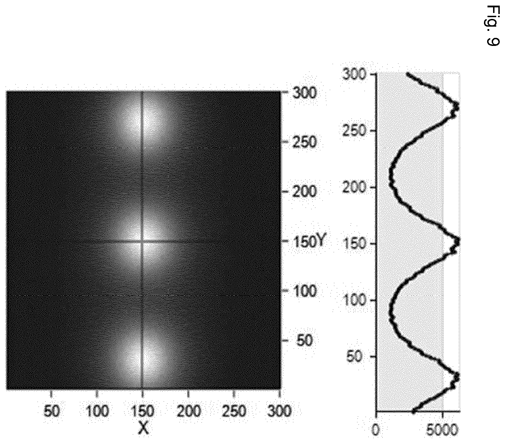

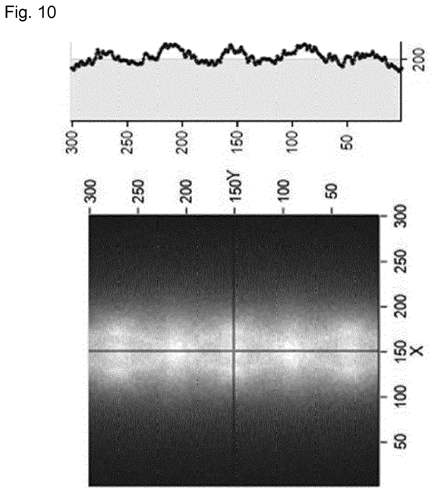

FIGS. 8 and 9 are views showing an illumination distribution of a linear lighting apparatus configured of a light emitting device package according to a comparative example, and FIG. 10 is a view showing an illumination distribution of a linear lighting apparatus configured of a light emitting device package according to an embodiment of the present invention. Here, the unit of the numerical values shown in FIGS. 8 to 10 is mm, and X and Y respectively indicate a first direction and a second direction intersecting the first direction.

Referring to FIG. 8, a linear lighting apparatus may be configured by arranging a plurality of light emitting device packages that are point light sources in a row. The light emitting device package including the square-shaped light emitting device according to a comparative example may have an isotropic illumination distribution, and therefore the number of the light emitting device packages required in a configuration of the linear lighting apparatus is relatively large.

Referring to FIG. 9, in a case in which the linear lighting apparatus is configured by arranging the light emitting device packages including the square-shaped light emitting device according to a comparative example in a row, when the number of the light emitting device packages in the linear lighting apparatus of FIG. 8 is reduced by half, each of the light emitting device packages is visually recognized as a point light source rather than as a linear light source.

Referring to FIG. 10, in a case in which the linear lighting apparatus is configured by arranging the plurality of light emitting device packages according to an embodiment of the present invention in a row, by arranging the light emitting device packages in the direction of the short axis in a row, in which the light emitted from the light emitting device package is widely diffused, each of the light emitting device packages may be visually recognized as the linear light source although the number of the light emitting device packages is reduced in the same manner as in a linear lighting module of FIG. 9.

As described above, according to the light emitting device package and the light apparatus including the same according to the embodiments of the present invention, the light emitting device may be formed into a rectangular shape or a plurality of light emitting devices may be arranged in a rectangular shape, and therefore an anisotropic illumination distribution may be obtained while applying an isotropic lens which can be easily designed and manufactured, thereby reducing manufacturing time and costs while increasing optical efficiency.

It will be apparent to those skilled in the art that various modifications can be made to the above-described exemplary embodiments of the present invention without departing from the scope of the invention. Thus, it is intended that the present invention covers all such modifications provided they come within the scope of the appended claims.

## Claims

1. A light emitting device package comprising:

   a rectangular light emitting device (120) that has a first side extending in a first direction and a second side extending in a second direction, and is disposed on a substrate (110); and
   a molding unit (130) disposed on the substrate (110) to surround the light emitting device (120), wherein a square root of {(length of the first side)$^2$ + (length of the second side)$^2$} is smaller than a diameter of the isotropic lens, and the length of the first side is at least 5/3 times more than the length of the second side, and a plurality of the rectangular light emitting devices (120) is arranged in the first direction and the second direction,
   **characterized in that**
   the molding unit has a shape of an isotropic lens; and
   the number of the plurality of the rectangular light emitting devices (120) arranged in the first direction is at least 5/3 times more than the number of the plurality of the rectangular light emitting devices (120) arranged in the second direction.

2. The light emitting device package of claim 1, wherein the isotropic lens has an aspherical surface shape with its center recessed.

## Patentansprüche

1. Lichtemittierungsvorrichtungsbaugruppe umfassend:

eine rechteckige Lichtemittierungsvorrichtung (120), die eine sich in einer ersten Richtung erstreckende erste Seite und eine sich in einer zweiten Richtung erstreckende zweite Seite aufweist, und auf einem Substrat (110) angeordnet ist; und

eine Formeinheit (130), die auf dem Substrat (110) angeordnet ist, um die Lichtemittierungsvorrichtung (120) zu umgeben,

wobei eine Quadratwurzel von {(Länge der ersten Seite)$^2$+(Länge der zweiten Seite)$^2$} kleiner als ein Durchmesser der isotropen Linse ist, und die Länge der ersten Seite wenigstens 5/3-mal mehr als die Länge der zweiten Seite ist, und

eine Vielzahl der rechteckigen Lichtemittierungsvorrichtungen (120) in der ersten Richtung und der zweiten Richtung angeordnet ist, **dadurch gekennzeichnet, dass**

die Formeinheit eine Form einer isotropen Linse aufweist; und

die Anzahl der Vielzahl der rechteckigen Lichtemittierungsvorrichtungen (120), die in der ersten Richtung angeordnet sind, wenigstens 5/3-mal mehr als die Anzahl der Vielzahl der rechteckigen Lichtemittierungsvorrichtungen (120) ist, die in der zweiten Richtung angeordnet sind.

2. Lichtemittierungsvorrichtungsbaugruppe nach Anspruch 1, wobei die isotrope Linse eine asphärische Oberflächenform mit ausgespartem Zentrum aufweist.

**Revendications**

1. Un boîtier de dispositif émetteur de lumière comprenant :

un dispositif émetteur de lumière rectangulaire (120) qui a un premier côté s'étendant dans une première direction et un deuxième côté s'étendant dans une deuxième direction, et qui est disposé sur un substrat (110) ; et

une unité de moulage (130) disposée sur le substrat (110) pour entourer le dispositif émetteur de lumière (120),

une racine carrée de {(longueur du premier côté)$^2$ + (longueur du deuxième côté)$^2$} est inférieure à un diamètre de la lentille isotrope, et la longueur du premier côté est d'au moins 5/3 fois supérieure à la longueur du deuxième côté, et

une pluralité de dispositifs émetteurs de lumière (120) rectangulaires est disposée dans la première direction et la deuxième direction, **caractérisé en ce que** l'unité de moulage a une forme de lentille isotrope ; et

le nombre de la pluralité des dispositifs émetteurs de lumière (120) rectangulaires disposés dans la première direction est au moins 5/3 fois supérieur au nombre de la pluralité des dispositifs émetteurs de lumière (120) rectangulaires disposés dans la deuxième direction.

2. Le boîtier de dispositif émetteur de lumière selon la revendication 1, dans lequel la lentille isotrope a une forme de surface asphérique avec son centre aménagé en creux.

Fig. 1

Fig. 2

Fig. 3

Fig. 4

Fig. 5

Fig. 6

Fig. 7

Fig. 8

Fig. 9

Fig. 10

**EP 2 905 810 B1**

REFERENCES CITED IN THE DESCRIPTION

**Patent documents cited in the description**

- US 2013141920 A
- US 2013270581 A
- US 2011193112 A